# EUROPÄISCHE PATENTSCHRIFT

(11) **EP 0 736 881 B1**
(45) Veröffentlichungstag und Bekanntmachung des Hinweises auf die Patenterteilung: **24.05.2000**
(21) Anmeldenummer: 96200576.5
(22) Anmeldetag: 04.03.1996
(51) Int. Cl.: H01C 7/00

(54) **Elektrisches Widerstandsbauelement mit CrSi-Widerstandsschicht**
Electrical resistance device with CrSi resistance layer
Résistance électrique comprenant une couche résistive en CrSi

(30) Priorität: 09.03.1995 DE 19508387
(43) Veröffentlichungstag der Anmeldung: 09.10.1996
(73) Patentinhaber: Philips Corporate Intellectual Property GmbH, 52064 Aachen (DE); FRAUNHOFER-GESELLSCHAFT ZUR FÖRDERUNG DER ANGEWANDTEN FORSCHUNG E.V., 80636 München (DE); Koninklijke Philips Electronics N.V., 5621 BA Eindhoven (NL)
(72) Erfinder: Veyhl, Rainer, Dipl.-Ing., D-22335 Hamburg (DE); Thyen, Rudolf, Dipl.-Ing., D-22335 Hamburg (DE); Boness, Henning, Dipl.-Ing., D-22335 Hamburg (DE)
(74) Vertreter: Volmer, Georg, Dipl.-Ing.

(56) Entgegenhaltungen:
- EP-A- 0 350 961
- EP-A- 0 370 478
- US-A- 4 517 444
- PATENT ABSTRACTS OF JAPAN vol. 012, no. 055 (M-669), 19.Februar 1988 & JP 62 202756 A (TDK CORP), 7.September 1987
- "32nd Electronic Components Conference" 10.Mai 1982 , IEEE , SAN DIEGO,CALIFORNIA XP002027862 T.KAMEI et al:"Structural and Electrical Properties of Cr-Si-O Thin Film Resistors" pages 481-487 * das ganze Dokument *
- WOLFGANG BREMSER: "Grundlagen und Anwendungsmöglichkeiten der Röntgenelektronenspektroskopie", CHEMIKER ZEITUNG, Band 95, Nr. 19, Seiten 819 -

## Beschreibung

Die Erfindung betrifft ein elektrisches Widerstandsbauelement bestehend aus einer oder mehreren Widerstandsschichten, gegebenenfalls auf einem Substrat, mit mindestens einer Widerstandsschicht auf CrSi-Basis, die 5 - 50 Atom-% Cr, 10 - 70 Atom-% Si, 5 - 50 Atom-% O und mindestens ein Element aus der Gruppe B, C und N in einer Konzentration von 1 - 50 Atom-% enthält.

Aufgrund der fortschreitenden Miniaturisierung von elektronischen Geräten werden hochohmige elektrische Präzisionswiderstandsbauelemente benötigt, die neben den Präzisionsanforderungen ebenfalls in bezug auf geometrische Abmessungen und Verlustwärme dieser Entwicklung nachkommen. Die Verlustwärme kann durch den Einsatz von hochohmigen Bauelementen reduziert werden. Gefordert werden Widerstandswerte > 1 MOhm bei geometrischen Abmessungen des Widerstandsbauelementes um 1 mm.

Durch eine geeignete Strukturierung der elektrischen Widerstandsschicht (Wendeln bei zylindrischen bzw. Mäandrieren bei flachen Widerstandskörpern) läßt sich aus dem Grundwert der elektrischen Widerstandsschicht ein bestimmter Endwert einstellen. Da aus Stabilitätsgründen sowohl eine minimale Bahnbreite als auch eine minimale Schichtdicke nicht unterschritten werden dürfen, wird das maximal erreichbare Grundwert/Endwertverhältnis durch die geometrischen Abmessungen des Widerstandskörpers begrenzt. Beide Anforderungen - kleine Baugröße und geringe Verlustwärme - können deshalb nur durch den Einsatz von Widerstandsschichtmaterialien mit möglichst hohem spezifischem Widerstand erreicht werden.

Als verbessertes Widerstandsmaterial wurde in der EP 0220 926 A2 ein Dünnschicht-Chrom-Silizium-Kohlenstoff-Widerstandsmaterial vorgeschlagen, das ungefähr 25 bis 35 Gew.-% Chrom, ungefähr 40 bis 55 Gew.-% Silizium und ungefähr 20 bis 30 Gew.-% Kohlenstoff umfaßt und durch einen Widerstand von mehr als 800 bis weniger als 1200 Ohm/in², einen Temperaturkoeffizient des Widerstandes von weniger als 200 ppm /K und einer absoluten Lebensdauer und Abgleichungsstabilität von weniger als 0,1 % des Widerstandes charakterisiert ist.

Weiterhin ist aus der EP 0 350 961 ein Halbleiterbauteil mit einer Widerstandsschicht der Zusammensetzung Cr₁(14%)Si₂(29%)O₁₋₅(21%)N₁₋₅(21%)C₁(14%) bekannt.

Die Aufgabe der Erfindung besteht darin, ein elektrisches Widerstandsbauelement zur Verfügung zu stellen, mit dem ein minimaler TCR, beispielsweise im Bereich von ±100 ppm/K, realisiert werden kann, mit dessen Einsatz, insbesondere für hochohmige elektrische Widerstandsbauelemente mit Widerstandswerten in der Größenordnung 1 MOhm bei geometrischen Abmessungen des Widerstandsbauelementes um 1 mm, die Streuung der Widerstandswerte innerhalb einer Beschichtungscharge sowie die Reproduzierbarkeit bestimmter Widerstandswerte von Beschichtungscharge zu Beschichtungscharge und somit die Ausbeute eines Beschichtungsprozesses gegenüber herkömmlichen Beschichtungsverfahren verbessert werden kann.

Erfindungsgemäß wird die Aufgabe gelöst durch ein elektrisches Widerstandsbauelement bestehend aus einer oder mehreren Widerstandsschichten, gegebenenfalls auf einem Substrat, mit mindestens einer Widerstandsschicht auf CrSi-Basis, die 5 - 50 Atom-% Cr, 10 - 70 Atom-% Si, 5 - 50 Atom-% O und mindestens ein Element aus der Gruppe B, C und N in einer Konzentration von 1 - 50 Atom-% enthält, dadurch gekennzeichnet, daß die elektrische Widerstandsschicht zusätzlich 1 - 5 Atom-% Ni, Co, Fe, Al, W, Mo, Ti, Ru, oder Cu enthält.

Das Wesen der Erfindung beruht außerdem auf dem reaktiven Einbau von Sauerstoff *und* Kohlenstoff bzw. von Sauerstoff *und* Stickstoff bzw. von Sauerstoff *und* Kohlenstoff *und* Stickstoff in elektrische Widerstandsschichten auf CrSi-Basis. Ein derartiges Widerstandsbauelement zeichnet sich dadurch aus, daß es eine sehr kleine Streuung und eine deutlich verbesserte Reproduzierbarkeit der Widerstandswerte aufweist. Es zeichnet sich weiterhin dadurch aus, daß es hochohmig ist mit Werten des spezifischen Widerstandes nahe 0 ppm/K (ρ_{TCR→0}) bis über 100.000 µOhm cm. Es ist daher besonders als hochohmiges elektrisches Präzisionswiderstandsbauelement für extreme klimatische und elektrische Beanspruchung geeignet. Es ist außerdem temperaturstabil, so daß es selbst bei Temperaturen um 500°C noch nicht nennenswert oxidiert. Außerdem ist es im TK100-Bereich temperbar. Wenn es als Flächenwiderstand in Dünnschichttechnik hergestellt wird, erhält man Werte von R > 20 kOhm/Quadrat (entsprechend einem spez. Widerstand von > 200 000 µOhm cm bei 100 nm Schichtdicke) und TCR < 100 ppm/K.

Bevorzugt ist ein elektrisches Widerstandsbauelement, das dadurch gekennzeichnet ist, daß die Widerstandsschicht auf CrSi-Basis 20 - 40 Atom-% Cr, 10 - 30 Atom-% Si, 10 - 40 Atom-% O und mindestens ein Element aus der Gruppe B, C und N in einer Konzentration von 1 - 40 Atom-% enthält.

Bevorzugt ist auch ein elektrisches Widerstandsbauelement, bei dem die Widerstandsschicht auf CrSi-Basis 25 - 35 Atom-% Cr, 15 - 25 Atom-% Si, 20 - 30 Atom-% O und mindestens ein Element aus der Gruppe B, C und N in einer Konzentration von 1 - 30 Atom-% enthält.

Ebenso ist es bevorzugt, daß die Widerstandsschicht auf CrSi - Basis 10 - 30 Atom-% Cr, 20 - 60 Atom-% Si, 20 - 50 Atom-% O und mindestens ein Element aus der Gruppe B, C und N in einer Konzentration von 1 - 40 Atom-% enthält.

Es ist besonders bevorzugt, daß die Widerstandsschicht auf CrSi- Basis 16 - 20 Atom-% Cr, 35 - 45 Atom-% Si, 20 - 30 Atom-% O und 15 -25 Atom-% C enthält.

Es kann auch bevorzugt sein, daß die Widerstandsschicht auf CrSi-Basis zusätzlich 1 - 20 Atom-% Wasserstoff enthält.

Es kann weiterhin bevorzugt sein, daß die Schichtdicke der elektrischen Widerstandsschicht auf CrSi - Basis 10 nm bis 10 µm beträgt.

Es ist bevorzugt, daß das Substrat aus Al₂O₃, BN, AlN, Si, SiC, Si₃N₄ und/oder SiO₂ besteht.

Nachfolgend wird die Erfindung näher erläutert.

Ein elektrisches Widerstandsbauelement nach der Erfindung kann ein diskretes Bauelement oder ein integriertes Bauelement sein. Es besteht im allgemeinen aus aus einer oder mehreren Widerstandsschichten auf einem Substrat sowie Anschlüssen. Die erfindungsgemäßen Widerstandsschichten enthalten Chrom, Silizium, Sauerstoff und mindestens ein Element aus der Gruppe Bor, Kohlenstoff und Stickstoff. Sauerstoff, Bor, Kohlenstoff und Stickstoff liegen dabei in oxidischer, boridischer, carbidischer bzw. nitridischer Bindung oder als elementare Einschlüsse in den Schichten vor.

Die Widerstandsschichten, die den eigentlichen Widerstandskörper bilden, können sich allein aus den erfindungsgemäßen Widerstandsschichten zusammensetzen, sie können aber auch mit herkömmlichen Widerstandsschichten kombiniert werden. Beispielsweise können sie mit weiterenWiderstandsschichten kombiniert werden, die Ni, Co, Fe, Al, W, Mo, Ti, Ru, oder Cu enthalten.

Bevorzugt werden die Widerstandsschichten auf einem Substrat aufgebracht. Das Substrat kann aus Al₂O₃, BN, AlN, Si, SiC, Si₃N₄ und/oder SiO₂ bestehen. Die Dicke der auf einem Substrat aufgebrachten Schichten beträgt im allgemeinen 10 nm bis 50µm, bevorzugt jedoch 50 bis 500 nm.

Die Abscheidung der elektrischen Widerstandsschicht auf das Substrat kann mittels herkömmlicher Schichtabscheidungsmethoden wie Tauchen, Aufsprühen oder Aufdampfen im Vakuum erfolgen. Vorzugsweise werden die Schichten jedoch durch reaktives Kathodenzerstäuben (reaktives Sputtern) aufgebracht. Chrom und Silizium werden beim reaktiven Kathodenzerstäuben physikalisch durch lonenbeschuß von einem festen Target zerstäubt, die Elemente O, C, B und N werden in Form gasförmiger Ausgangsverbindungen in die Beschichtungskammer eingebracht. Durch Plasmaaktivierung werden diese gasförmigen Ausgangsverbindungen angeregt und bilden sehr reaktive Teilchen, die zusammen mit dem physikalisch zerstäubten Cr und Si auf dem Substrat abgeschieden werden. Der Prozeß des reaktiven Kathodenzerstäubens ist damit eine Kombination von PVD und CVD.

Alternativ kann ein Verfahren verwendet werden, bei dem physikalisch durch lonenbeschuß Targets zerstäubt werden, die Oxide, Carbide, Nitride, Boride oder andere feste Verbindungen der Elemente O, C, B, N enthalten.

Dabei werden ein oder mehrere Targets mit der gleichen Zusammensetzung oder mit unterschiedlichen Zusammensetzungen CrₓSi_{y} eingesetzt. Es können auch ein oder mehrere Targets mit gleichen oder unterschiedlichen Zusammensetzungen CrₓSi_{y}R_{z} eingesetzt werden, wobei R eines oder mehrere der oben genannten Elemente, wie beispielsweise O, B, C, N oder auch H, Ge, Ni, Co, Fe, Al, W, Mo, Ti, Ru oder Cu, sein kann. Der Si-Anteil im Target kann zu 0 - 100 % (relativ) durch Ge ersetzt sein. Insbesondere sauerstoffhaltige CrₓSi_{y}O_{z}-Cermet-Targets haben sich als geeignet erwiesen.

Die Zusammensetzung x:y des verwendeten CrₓSi_{y}-Targetmaterials liegt zwischen 0 : 100 und 100 : 0, vorzugsweise zwischen 20 : 80 und 60 : 40. Als besonders geeignet hat sich eine Zusammensetzung zwischen 30 : 70 und 50 : 50 erwiesen. Bei Verwendung von CrₓSi_{y}R_{z}-Targetmaterialien entspricht x : y der Zusammensetzung wie oben und (x+y):z liegt zwischen 0 : 100 und 100 : 0, vorzugsweise zwischen 90 : 10 und 50 : 50.

Die Abscheidung erfolgt unter einer reaktivgashaltigen Atmosphäre, die im speziellen Anwendungsfall bei Verwendung von CrₓSi_{y}R_{z}-Targetmaterialien nicht reaktivgashaltig sein muß, auf ein Substrat, beispielsweise aus Al₂O₃, AlN, BN, Si, SiC, Si₃N₄ und/oder SiO₂.

Als Reaktivgase, in denen der Sauerstoff an ein anderes Element gebunden vorliegt, können beispielsweise Kohlendioxid (CO₂), Kohlenmonoxid (CO), Lachgas (N₂O), Stickstoffmonoxid (NO), Stickstoffdioxid (NO₂) oder auch sauerstoff-, wasserstoff- und siliciumhaltige Reaktivgase wie beispielsweise Hexamethyldisiloxan (HMDSO, (CH₃)₃SiOSi(CH₃)₃) oder Hexamethylcyclotrisiloxan (HMCTSO, ((CH₃)₂SiO)₃) eingesetzt werden. Alle diese Reaktivgase haben im Vergleich zu Wasser (H₂O) den Vorteil, daß die Neigung zur Adsorption an kalten Oberflächen wesentlich geringer ausgeprägt ist, so daß sich ein während des Beschichtungsprozesses konstanter Reaktivgaspartialdruck, beispielsweise mit Hilfe eines Gasflußreglers, problemlos einstellen läßt.

Zur Erhöhung des Sauerstoffgehaltes in der abzuscheidenden elektrischen Widerstandsschicht kann den oben genannten Reaktivgasen bzw. Reaktivgasgemischen, die mindestens aus einer Reaktivgasart bestehen, in der der Sauerstoff an ein anderes Element gebunden vorliegt, zusätzlich molekularer Sauerstoff (O₂) und/oder Wasser (H₂O) beigegeben werden. Zur Erhöhung des Kohlenstoff- und/oder Stickstoff- und/oder Borgehaltes in der abzuscheidenden elektrischen Widerstandsschicht können den oben genannten Reaktivgasen bzw. Reaktivgasgemischen, die mindestens aus einer Reaktivgasart bestehen, in der der Sauerstoff an ein anderes Element gebunden vorliegt, zusätzlich weitere Reaktivgase, wie beispielsweise Kohlenwasserstoff (CₓH_{y}) und/oder molekularer Stickstoff (N₂) und/oder Ammoniak (NH₃) und/oder Trimethylborazol TMB, (CH₃)₃B₃N₃) beigegeben werden.

Durch eine anschließende thermische Nachbehandlung kann die auf dem Substrat abgeschiedene Widerstandsschicht vorgealtert werden. Die Nachbehandlung erfolgt in der Regel in einem mehrstündigen Temperprozeß bei 200 - 700°C in Luft oder unter Schutzgas oder unter Vakuum, vorzugsweise 2 - 6 Stunden bei 400 - 600°C an Luft. Außerdem kann durch Veränderung der Schichtstruktur als Folge der Temperung (Kristallisierung) der TCR so verändert werden, daß dieser in den Bereich von beispielsweise ±100 ppm/K verschoben wird.

## Patentansprüche

1. Elektrisches Widerstandsbauelement bestehend aus einer oder mehreren Widerstandsschichten, gegebenenfalls auf einem Substrat, mit mindestens einer Widerstandsschicht auf CrSi-Basis, die 5 - 50 Atom-% Cr, 10 - 70 Atom-% Si, 5 - 50 Atom-% O und mindestens ein Element aus der Gruppe B, C und N in einer Konzentration von 1 - 50 Atom-% enthält,
dadurch gekennzeichnet,
daß die elektrische Widerstandsschicht zusätzlich 1 - 5 Atom-% Ge, Ni, Co, Fe, Al, W, Mo, Ti, Ru, oder Cu enthält.

2. Elektrisches Widerstandsbauelement nach Anspruch 1,
dadurch gekennzeichnet,
daß die Widerstandsschicht auf CrSi-Basis 20 - 40 Atom-% Cr, 10 - 30 Atom-% Si, 10 - 40 Atom-% O und mindestens ein Element aus der Gruppe B, C und N in einer Konzentration von 1 - 40 Atom-% enthält.

3. Elektrisches Widerstandsbauelement nach Anspruch 1,
dadurch gekennzeichnet,
daß die Widerstandsschicht auf CrSi-Basis 25 - 35 Atom-% Cr, 15 - 25 Atom-% Si, 20 - 30 Atom-% O und mindestens ein Element aus der Gruppe B, C und N in einer Konzentration von 1 - 30 Atom-% enthält.

4. Elektrisches Widerstandsbauelement nach Anspruch 1,
dadurch gekennzeichnet, daß die Widerstandsschicht auf CrSi-Basis 10 -30Atom-% Cr, 20 -60Atom-% Si, 20 - 50 Atom-% O und mindestens ein Element aus der Gruppe B, C und N in einer Konzentration von 1 - 40 Atom-% enthält.

5. Elektrisches Widerstandsbauelement nach Anspruch 1,
dadurch gekennzeichnet,
daß die Widerstandsschicht auf CrSi- Basis 16 - 20 Atom-% Cr, 35 - 45 Atom-% Si, 20 - 30 Atom-% O und 15 - 25 Atom-% C enthält.

6. Elektrisches Widerstandsbauelement nach Anspruch 1,
dadurch gekennzeichnet,
daß die Widerstandsschicht auf CrSi-Basis zusätzlich 1 - 20 Atom-% Wasserstoff enthält.

7. Elektrisches Widerstandsbauelement nach Anspruch 1,
dadurch gekennzeichnet,
daß die Schichtdicke der elektrischen Widerstandschicht auf CrSi - Basis 10 nm bis 10 µm beträgt.

8. Elektrisches Widerstandsbauelement nach Anspruch 1,
dadurch gekennzeichnet,
daß das Substrat aus Al₂O₃, BN, AlN, Si, SiC, Si₃N₄ und/oder SiO₂ besteht.

## Claims

1. A resistive component which is composed of one or more resistive films which, if necessary, may be provided on a substrate, with at least one resistive film being on the basis of CrSi, and comprising 5-50 at.% Cr, 10-70 at.% Si, 5-50 at.% O and at least an element of the group formed by B, C and N in a concentration in the range from 1 to 50 at.%, characterized in that the resistive film additionally comprises 1-5 at.%. Ge, Ni, Co, Fe, Al, W, Mo, Ti, Ru, or Cu.

2. A resistive component as claimed in Claim 1, characterized in that the resistive film on the basis of CrSi comprises 20-40 at.% Cr, 10-30 at.% Si, 10-40 at.% O and at least one element of the group formed by B, C and N in a concentration of 1-40 at.%.

3. A resistive component as claimed in Claim 1, characterized in that the resistive film on the basis of CrSi comprises 25-35 at.% Cr, 15-25 at.% Si, 20-30 at.% O, and at least one element of the group formed by B, C and N in a concentration of 1-30 at.%.

4. A resistive component as claimed in Claim 1, characterized in that the resistive film on the basis of CrSi comprises 10-30 at.% Cr, 20-60 at.% Si, 20-50 at.% O, and at least one element of the group formed by B, C and N in a concentration of 1-40 at.%.

5. A resistive component as claimed in Claim 1, characterized in that the resistive film on the basis of CrSi comprises 16-20 at.% Cr, 35-45 at.% Si, 20-30 at.% O and 15-25 at.% C.

6. A resistive component as claimed in Claim 1, characterized in that the resistive film on the basis of CrSi additionally comprises 1-20 at.% hydrogen.

7. A resistive component as claimed in Claim 1, characterized in that the thickness of the resistive film on the basis of CrSi ranges from 10 nm to 10µm.

8. A resistive component as claimed in Claim 1, characterized in that the substrate is composed of Al₂O₃, BN, AlN, Si, SiC, Si₃N₄ and/or SiO₂.

## Revendications

1. Module de résistance électrique composé d'une ou plusieurs couches résistives, éventuellement sur un substrat avec au moins une couche résistive à base CrSi qui contient 5 à 50% en atome de Cr, 10 à 70% en atome de Si, 5 à 50% en atome de O et au moins un élément du groupe B, C et N dans une concentration de 1 à 50% en atome,
caractérisé en ce
que la couche résistive électrique contient par ailleurs 1 à 5% en atome de Ge, Ni, Co, Fe, Al, W, Mo, Ti, Ru ou Cu.

2. Module de résistance électrique selon la revendication 1,
caractérisé en ce
que la couche résistive à base de CrSi se compose de 20 à 40% en atome de Cr, 10 à 30% en atome de Si, 10 à 40% en atome de O et au moins un élément du groupe B, C et N dans une concentration de 1 à 40% en atome.

3. Module de résistance électrique selon la revendication 1,
caractérisé en ce
que la couche résistive à base de CrSi se compose de 25 à 35% en atome de Cr, 15 à 25% en atome de Si, 20 à 30% en atome de O et au moins un élément du groupe B, C et N dans une concentration de 1 à 30% en atome.

4. Module de résistance électrique selon la revendication 1,
caractérisé en ce que la couche résistive à base de CrSi se compose de 10 à 30% en atome de Cr, 20 à 60% en atome de Si, 20 à 50% en atome de O et au moins un élément du groupe B, C et N dans une concentration de 1 à 40% en atome.

5. Module de résistance électrique selon la revendication 1,
caractérisé en ce que la couche résistive à base de CrSi se compose de 16 à 20% en atome de Cr, 35 à 40% en atome de Si, 20 à 30% en atome de O et 15 à 20% en atome de C.

6. Module de résistance électrique selon la revendication 1,
caractérisé en ce
que la couche résistive à base de CrSi se compose par ailleurs de 1 à 20% en atome d'hydrogène.

7. Module de résistance électrique selon la revendication 1,
caractérisé en ce que l'épaisseur de la couche résistive électrique à base de CrSi s'élève à 10 nm à 10 µm.

8. Module de résistance électrique selon la revendication 1,
caractérisé en ce que le substrat se compose d'Al₂O₃, BN, AlN, Si, SiC, Si₃N₄ et/ou SiO₂.
